# EUROPEAN PATENT SPECIFICATION

(11) **EP 3 903 301 B1**
(45) Date of publication and mention of the grant of the patent: **07.06.2023**
(21) Application number: 19835523.2
(22) Date of filing: 23.12.2019
(51) Int. Cl.: G09F 3/00, C30B 29/04

(54) **USE OF A LASER TO CUT A SLICE OF A SYNTHETIC DIAMOND AND TO ENGRAVE BOTH THE SLICE AND THE REMAINING PART**
VERWENDUNG EINES LASERS, UM EINE SCHEIBE EINES SYNTHETISCHEN DIAMANTEN ZU SCHNEIDEN UND SOWOHL DIE SCHEIBE ALS AUCH DEN VERBLEIBENDEN TEIL ZU GRAVIEREN
UTILISATION D'UN LASER POUR COUPER UNE TRANCHE D'UN DIAMANT SYNTHÉTIQUE ET POUR GRAVER À LA FOIS LA TRANCHE ET LA PARTIE RESTANTE

(30) Priority: 27.12.2018 BE 201805952
(43) Date of publication of application: 03.11.2021
(73) Proprietor: FSF PTE LTD, 068898 Singapore (SG)
(72) Inventor: PARIKH, Naman Saurin, Dubai (AE)
(74) Representative: Donné, Eddy
(86) International application number: PCT/IB2019/061281
(87) International publication number: WO 2020/136551

(56) References cited:
- US-A1- 2017 365 194

## Description

The present invention relates to a method for identification of a synthetic diamond.

In particular, the invention is intended for the identification and registration of a synthetic diamond.

A synthetic diamond distinguishes itself from a natural diamond because it is the result of technological processes instead of geological processes for a natural diamond.

It is known that synthetic diamond can be manufactured by applying very high pressures and temperatures (High Pressure High Temperature or HPHT process) under laboratory conditions, but also by applying chemical vapour deposition (or CVD process) under laboratory conditions.

The HPHT process usually occurs in a reactor chamber in which temperatures and pressures can be generated which are designed to approximate the conditions under which natural diamond is formed in the earth.

Elements are added in a growth chamber that will stimulate the growth of diamonds: a carbon rich material such as diamond powder, a metal catalyst such as iron, nickel and cobalt and a small "seed" diamond that serves as mould on which the diamond will form. Once pressures of approximately 5 to 6 GP and temperatures of 1300°C or more are achieved, the carbon rich material is absorbed by the metal catalyst to a certain saturation point. A temperature gradient in the growth chamber then allows carbon atoms to start crystallising on the seed diamond.

Depending on the desired size of the finished crystal, the process may take a couple of weeks to a couple of months. The growth form of the finished crystal is influenced by the temperature, but the predominant form is cubo-octahedral. No further processing is necessary before the diamond can be polished.

The CVD process usually occurs under strict conditions in a vacuum chamber and uses carbon rich gases such as hydrocarbons and methane. Typically, these gases are then brought to below atmospheric pressure and heated to 700-1200°C where gas activation commences.

As the bonds in the gases begin to break, carbon atoms begin to attach to a substrate of diamond in the vacuum chamber, usually a square diamond crystal slice, also called "seed crystal".

The growth rates vary, but after 40 to 60 days a diamond with jewellery quality is formed that has grown atom by atom. The finished diamond has a cubic form and often shows a black graphite edge which is a normal characteristic of the growth process.

To prepare the finished diamond for planning and polishing, lasers are used to cut the core out of the centre of the rough diamond. The graphite edge is hereby removed and the pure diamond cube remains, which will now be further processed to become a finished cut diamond.

In the past it was never possible to determine the accurate age of a natural diamond, as a natural diamond can be up to more than a billion years old.

However, the growth process of synthetic diamond allows us to document the growth process of the diamond down to the second from start to end, by means of the technology used for its production.

Synthetic diamond offers the advantage that it gives an ethical assurance of a diamond grown on request thereby eliminating environmental concerns in natural diamond mining.

Natural cut diamonds can be certified and their certificate number can be engraved in the diamond. However, it is impossible to specify the date of birth of the natural diamond, as this is not exactly known.

US 2017/0365194 A1 describes a method for providing an identification code on a rough natural diamond by laser inscribing. An image of the diamond together with the diamond data, including the identification code, is saved in a computer system.

The purpose of the present invention is to provide a solution to the aforementioned and other disadvantages, by providing a method which allows the exact date of birth of a synthetic diamond to be shown, both on the synthetic diamond itself as on the accompanying certificate.

To this end, the invention relates to the use of a laser to cut a slice of a synthetic diamond and to engrave both the slice and the remaining part as claimed in claims 1 to 8.

A method is provided for showing the exact date of birth of a synthetic diamond, which at least comprises the following steps:
- cutting a slice off the synthetic diamond to be marked using a laser;
- engraving at least the date of birth of the synthetic diamond and a number of an accompanying certificate of authenticity, and optionally, additional information such as a brand logo by means of a laser;
- optionally engraving a personal message on the cut off slice and/or on the finished cut diamond derived from the remaining rough synthetic diamond;
- incorporating the engraved slice of the synthetic diamond to be marked in a certificate of authenticity which bears the same number under a transparent window in the certificate;
- engraving the same number of the accompanying certificate of authenticity on the finished cut diamond, derived from the remaining rough synthetic diamond, preferably on its girdle;

Obviously all desired information relating to the synthetically manufactured diamond can be put on the certificate, such as the weight and the dimensions of the cut diamond, the cut, the production method, the history and place of manufacture and optical characteristics such as the clarity.

The engraved slice attached to the accompanying certificate of authenticity will often be too small to read with the naked eye. The slice is located behind a transparent window and if necessary can be read with a magnifying glass with a X30 or X50 lens.

As an alternative destination the slice, with or without its certificate, can also be placed on the lid of the box, for example, in which the cut finished diamond is kept or offered.

Yet another alternative destination for the slice is that it can be incorporated in a jewel in the piece of jewellery itself or in an accompanying amulet which is worn together with the piece of jewellery for example.

With the intention of better showing the characteristics of the invention, a few preferred applications of the method for identification of a synthetic diamond according to the invention are described hereinafter by way of an example, without any limiting nature, with reference to the accompanying drawings, wherein:
figure 1 schematically shows a perspective view of a synthetic diamond cubo-octahedral crystal;
figure 2 schematically shows a perspective view of the growth phases of a synthetic diamond cubic crystal;
figure 3 schematically shows a perspective view of cutting a synthetic diamond out of its surrounding black graphite;
figure 4 shows a perspective view of a synthetic diamond slice, cut according to the method of the invention;
figure 5 shows a frontal view of a certificate of authenticity of a synthetic diamond according to the invention;
figure 6 shows a frontal view of a piece of jewellery, provided with a synthetic diamond slice according to the invention.

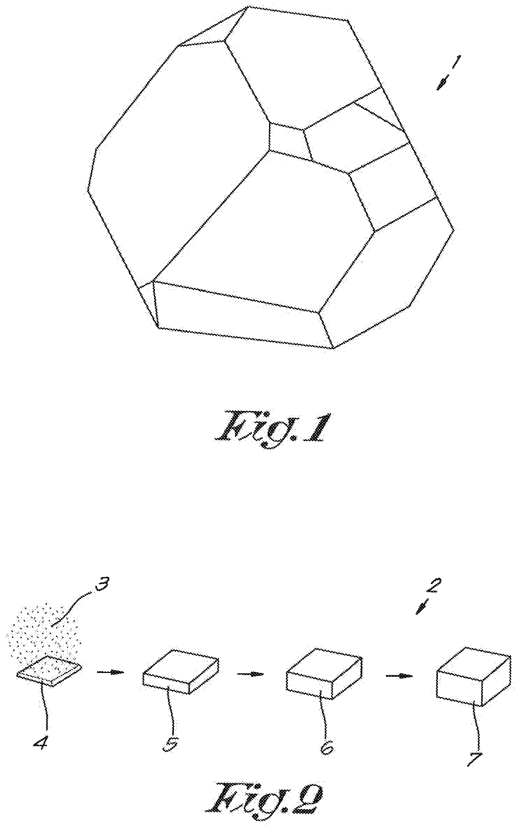

Figure 1 shows a perspective view of a synthetic diamond cubo-octahedral crystal 1, the predominant crystalline form of synthetic diamond manufactured with the HPHT process or high pressure and high temperature process. The process requires an extremely high pressure and takes a number of weeks to a number of months.

Figure 2 shows the growth process 2 of a synthetic diamond manufactured according to the CVD process or Chemical Vapour Deposition process whereby gaseous carbon 3 is deposited on a seed crystal 4 at a pressure lower than atmospheric pressure and at a high temperature. From left to right the formation is shown of, in this case, a synthetic diamond cubic crystal, based on a synthetic diamond square seed crystal 4 on which gaseous carbon 3 is deposited in consecutive steps 5, 6 until for example a synthetic diamond cube 7 is obtained.

The CVD process requires a growth period of approximately 40 to 60 days. As it grows, a ring of black graphite forms around the edge of the cubic crystal.

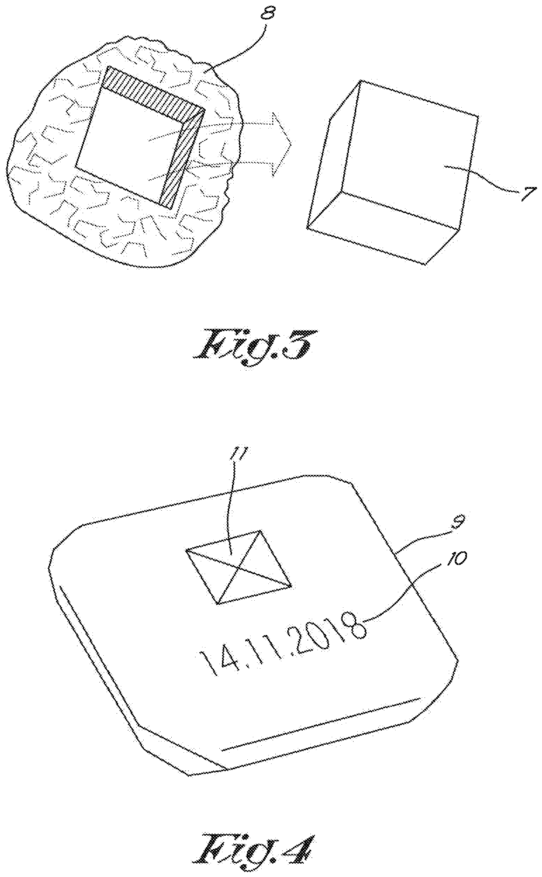

Figure 3 shows how the cubic crystal 7 of synthetic diamond is cut out of the surrounding ring of black graphite 8.

Figure 4 shows a diamond slice 9 cut off a synthetic diamond cubic crystal 7 by means of a laser according to the method of the invention. The slice 9 was cut off a synthetic diamond to be identified. At least the date of birth 10 and, optionally, additional information 11 are engraved on the slice by means of a laser.

The additional information 11 can be a number of an accompanying certificate of authenticity and/or a brand logo or a personal message.

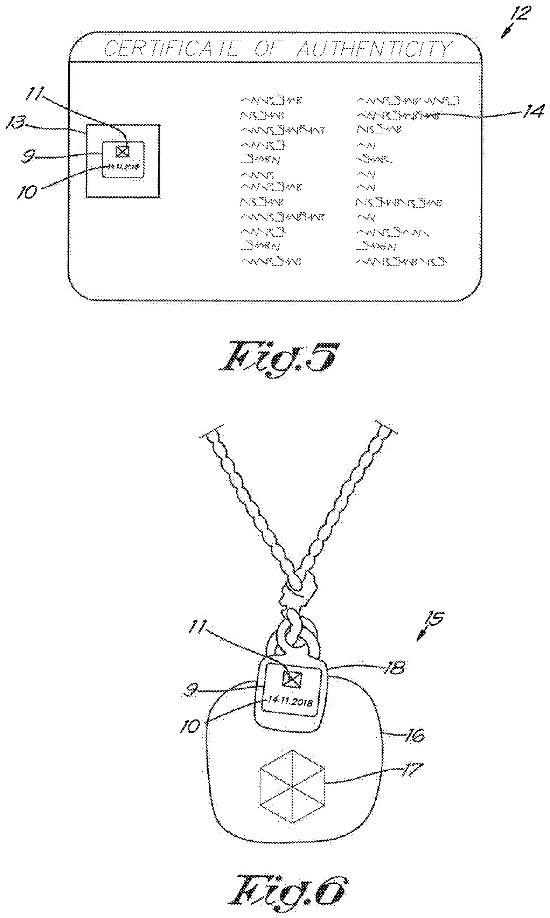

Figure 5 shows a certificate of authenticity 12 of a synthetic diamond according to the invention in which the diamond slice 9 cut off the diamond to be identified is integrated. The diamond slice 9 can be placed behind a transparent window 13 such that the engraved information 11 on said slice can be read at all times with the naked eye or with a magnifying glass of for example X30 or X50.

The certificate of authenticity 12 according to the invention specifies all desired information 14 relating to the synthetically manufactured diamond, a slice 9 of which is attached to the certificate and the remaining section of which is cut further in a chosen cut.

The information 14 may comprise the weight and the dimensions of the cut diamond, the cut, the production method, the history and place of manufacture and optical characteristics such as the clarity. The number of the certificate of authenticity is specified on the certificate 12 itself, but may also be engraved on the slice 9 located on the certificate 12 and may also be engraved on the final cut diamond derived from the synthetic diamond. It is also possible to engrave a personal message on the slice 9 and/or on the final cut diamond itself and to specify this message in the information 14 on the certificate.

Figure 6 shows a piece of jewellery 15 in the form of a pendant 16 in which the final cut diamond 17 is processed. In this case the piece of jewellery is provided with an amulet 18 which contains a synthetic diamond slice 9, on which the date of birth of the final cut diamond 17 and the additional information can be read according to the invention.

The application of the method for marking and identifying a synthetic diamond according to the invention is very simple and as follows.

A thin slice 9 of approximately 1 mm thickness is cut off a grown synthetic diamond 7 by means of a laser. On this slice 9 the date of birth of the synthetic diamond 10 is engraved, i.e. the day on which the synthetic diamond was obtained, and the number of an accompanying certificate of authenticity 12 and optionally further information 11 about the synthetic diamond such as a brand logo or brand name of the producer and/or place of production or also a personal message.

The slice 9 is included in an accompanying certificate of authenticity 12 whereby the information on the slice 9 can be read through a transparent window 13, possibly with a magnifying glass. The certificate of authenticity 12 may bear additional information, such as the weight and the dimensions of the final cut diamond 17, its cut, the history and place of manufacture and optical characteristics such as the clarity.

The number of the certificate of authenticity is also engraved on the slice 9 and may also be engraved on the final cut diamond 17, such that it is clear they belong together. The relationship between the slice 9 and the cut diamond 17 may also be indicated by engraving a personal message on the slice 9 and on the final cut diamond.

Thus the slice 9 and the accompanying cut diamond 17 may be sold or offered together, for example in the form of a box containing the cut diamond the lid of which contains the slice 9.

Thus the slice 9 and the accompanying cut diamond 17 may also be worn together in the form of a piece of jewellery 15 with the cut diamond 17, to which an amulet 18 with the slice 9 is attached for example.

An advantage of this invention is that it allows the usual history from diamond mine to market for a natural diamond to be mirrored in a synthetic diamond history from manufacture to finished market product, whereby an exact date of birth of the synthetic diamond can be provided.

The exact date of birth of the synthetic diamond is the date on which the completed rough synthetic diamond comes out of the machine with which it is manufactured. This synthetic diamond can be chosen to mark an event that takes place on exactly the same date of birth, for example a birth or a wedding, or on the same date in another year such as an anniversary, or on a date associated with the date of birth of the diamond, for example a birthday. The date of the event and the description of the event may also be included in the accompanying numbered certificate of authenticity included in the kit of parts.

This allows a buyer to choose a synthetic diamond with a desired date of birth from a series of available synthetic diamonds which each bear an exact date of birth. This is only possible for a synthetic diamond, the exact date of birth of which is known, unlike natural diamonds the exact date of birth of which will remain unknown.

## Claims

1. Use of a laser to cut a slice (9) of a synthetic diamond (7) and to engrave both the slice and the remaining part (17), **characterised in that** both the slice (9) and the remaining part (17), are engraved with the birthday of the original synthetic diamond and with the number of an accompanying certificate of authenticity, and **in that** the engraved slice of the synthetic diamond is incorporated in a certificate of authenticity which bears the same number of the accompanying certificate under a transparent window in the certificate, and **in that** the same number of the accompanying certificate of authenticity is engraved on the final cut diamond (17), derived from the remaining rough synthetic diamond, such that it is clear that the engraved slice (9) and the cut diamond (17) belong together.

2. Use of a laser according to claim 1, **characterised in that** both the slice (9) and the remaining part (17) are engraved with additional information (11).

3. Use of a laser according to claim 2, **characterised in that** the additional information comprises a brand logo of the synthetic diamond (7).

4. Use of a laser according to claim 2, **characterised in that** the additional information (11) comprises a personal message.

5. Use of a laser according to claim 1, **characterised in that** the number of the accompanying certificate (12) is engraved on the girdle of the finished cut diamond (17).

6. Use of a laser according to claim 1, **characterised in that** all the desired information (14) relating to the synthetic diamond is mentioned on the certificate, such as the weight and dimensions of the finished cut diamond (17), the diamond cut, the production method, the history and place of production and the optical characteristics such as the clarity.

7. Use of a laser according to claim 1, **characterised in that** the slice (9), with or without being placed in its linked certificate (12), is put on the lid of a box in which the finished cut diamond (17) is kept or offered.

8. Use of a laser according to claim 1, **characterised in that** the slice (9) is incorporated in a jewel (15) together with the linked finished and cut diamond (17) itself or in a linked amulet (18) that is worn together with the jewel.

## Patentansprüche

1. Verwendung eines Lasers zum Schleifen einer Scheibe (9) eines synthetischen Diamanten (7) und zum Eingravieren sowohl der Scheibe als auch des restlichen Teils (17), **dadurch gekennzeichnet, dass** sowohl die Scheibe (9) als auch der verbleibende Teil (17) mit dem Geburtstag des ursprünglichen synthetischen Diamanten und mit der Nummer eines beigefügten Echtheitszertifikats eingraviert werden, und dass die eingravierte Scheibe des synthetischen Diamanten in einem Echtheitszertifikat integriert wird, das die gleiche Nummer des beigefügten Zertifikats unter einem transparenten Fenster im Zertifikat trägt, und dass die gleiche Nummer des beigefügten Echtheitszertifikats auf den endgültigen geschliffenen Diamanten (17) eingraviert wird, der aus dem verbleibenden synthetischen Rohdiamanten abgeleitet ist, so dass klar ist, dass die eingravierte Scheibe (9) und der geschliffene Diamant (17) zusammengehören.

2. Verwendung eines Lasers nach Anspruch 1, **dadurch gekennzeichnet, dass** sowohl die Scheibe (9) als auch der verbleibende Teil (17) mit Zusatzinformationen (11) eingraviert sind.

3. Verwendung eines Lasers nach Anspruch 2, **dadurch gekennzeichnet, dass** die Zusatzinformationen ein Markenlogo des synthetischen Diamanten (7) umfassen.

4. Verwendung eines Lasers nach Anspruch 2, **dadurch gekennzeichnet, dass** die Zusatzinformationen (11) eine persönliche Nachricht umfassen.

5. Verwendung eines Lasers nach Anspruch 1, **dadurch gekennzeichnet, dass** die Nummer des beigefügten Zertifikats (12) auf der Schnur des fertig geschliffenen Diamanten (17) eingraviert wird.

6. Verwendung eines Lasers nach Anspruch 1, **dadurch gekennzeichnet, dass** alle gewünschten Informationen (14) in Bezug auf den synthetischen Diamanten auf dem Zertifikat erwähnt sind, wie das Gewicht und die Abmessungen des fertigen geschliffenen Diamanten (17), der Diamantschliff, die Herstellungsmethode, die Geschichte und der Herstellungsort und die optischen Eigenschaften wie die Klarheit.

7. Verwendung eines Lasers nach Anspruch 1, **dadurch gekennzeichnet, dass** die Scheibe (9), mit oder ohne Platzierung in ihrem verbundenen Zertifikat (12), auf den Deckel einer Schachtel gelegt wird, in der der fertig geschliffene Diamant (17) aufbewahrt oder angeboten wird.

8. Verwendung eines Lasers nach Anspruch 1, **dadurch gekennzeichnet, dass** die Scheibe (9) in einem Juwel (15) zusammen mit dem verbundenen fertigen und geschliffenen Diamanten (17) selbst oder in einem verbundenen Amulett (18) eingearbeitet wird, das zusammen mit dem Juwel getragen wird.

## Revendications

1. Utilisation d'un laser pour la taille d'une tranche (9) d'un diamant synthétique (7) et pour la gravure à la fois de la tranche et de la partie restante (17), **caractérisée en ce que** à la fois la tranche (9) et la partie restante (17) sont gravées avec la date de naissance du diamant synthétique original et avec le numéro d'un certificat d'authenticité qui lui est associé, et **en ce que** la tranche gravée du diamant synthétique est incorporée dans un certificat d'authenticité qui porte le même numéro du certificat qui lui est associé sous une fenêtre transparente dans le certificat, et **en ce que** le même numéro du certificat d'authenticité qui lui est associé est gravé sur le diamant (17) issu de sa taille finale, qui dérive du diamant synthétique brut restant, d'une manière telle qu'il est clair que la tranche gravée (9) et le diamant taillé (17) vont ensemble.

2. Utilisation d'un laser selon la revendication 1, **caractérisée en ce que** à la fois la tranche (9) et la partie restante (17), sont gravées avec des informations supplémentaires (11).

3. Utilisation d'un laser selon la revendication 2, **caractérisée en ce que** les informations supplémentaires comprennent un logo de marque du diamant synthétique (7).

4. Utilisation d'un laser selon la revendication 2, **caractérisée en ce que** les informations supplémentaires (11) comprennent un message personnel.

5. Utilisation d'un laser selon la revendication 1, **caractérisée en ce que** le numéro du certificat (12) qui lui est associé est gravé sur le cordon du diamant (17) issu de sa taille finale.

6. Utilisation d'un laser selon la revendication 1, **caractérisée en ce que** toutes les informations souhaitées (14) qui concernent le diamant synthétique sont mentionnées sur le certificat, à savoir le poids et les dimensions du diamant (17) issu de sa taille finale, la taille du diamant, le procédé de fabrication, l'historique et le lieu de fabrication, ainsi que les caractéristiques optiques telles que la pureté.

7. Utilisation d'un laser selon la revendication 1, **caractérisée en ce que** la tranche (9), insérée ou non dans son certificat (12) qui lui est associé, est placée sur le couvercle d'une boîte dans laquelle le diamant (17) issu de sa taille finale est conservé ou offert.

8. Utilisation d'un laser selon la revendication 1, **caractérisée en ce que** la tranche (9) est incorporée dans un bijou (15) de manière conjointe avec le diamant lui-même (17) issu de sa taille finale (17) qui lui est associé ou dans un porte-bonheur (18) qui lui est associé, qui est porté de manière conjointe avec le bijou.
